(19) Europäisches Patentamt
European Patent Office
Office européen des brevets

(11) **EP 0 801 745 B1**

(12) **EUROPEAN PATENT SPECIFICATION**

(45) Date of publication and mention
of the grant of the patent:
**23.01.2008 Bulletin 2008/04**

(51) Int Cl.:
*G01R 19/25* $^{(2006.01)}$    *G01R 23/165* $^{(2006.01)}$
*G01R 25/00* $^{(2006.01)}$

(21) Application number: **96938568.1**

(22) Date of filing: **24.10.1996**

(86) International application number:
**PCT/SE1996/001366**

(87) International publication number:
**WO 1997/016738 (09.05.1997 Gazette 1997/20)**

(54) **MEASURING METHOD FOR DETERMINING THE AMPLITUDE AND PHASE OF THE FUNDAMENTAL TONE OF AN ALTERNATING VOLTAGE**

MESSVERFAHREN ZUR BESTIMMUNG DER AMPLITUDE UND PHASE DER GRUNDSCHWINGUNG EINER WECHSELSPANNUNG

PROCEDE DE MESURE SERVANT A DETERMINER L'AMPLITUDE ET LA PHASE DE LA TONALITE FONDAMENTALE D'UNE TENSION ALTERNATIVE

(84) Designated Contracting States:
**DE FR GB IT**

(30) Priority: **03.11.1995  SE 9503880**

(43) Date of publication of application:
**22.10.1997  Bulletin 1997/43**

(73) Proprietor: **ABB AB**
**721 83 Västerås (SE)**

(72) Inventors:
• **BRNCIC, Ivo**
  **S-722 44 Västeras (SE)**
• **HILLSTRÖM, Birger**
  **S-722 23 Västeras (SE)**
• **MAKOVAC, Valter**
  **S-722 31 Västeras (SE)**

(56) References cited:
**EP-A- 0 523 263          WO-A-95/06880**
**DE-C- 4 205 300**

• **IEEE TRANSACTIONS ON POWER DELIVERY, Volume 9, No. 3, July 1994, P.G. McLAREN et al., "Open Systems Relaying", pages 1316-1324.**

**Description**

TECHNICAL FIELD

The present invention relates to a method of measurement for determining the amplitude and phase of the fundamental tone/frequency and harmonics, if any, of an alternating voltage. The invention can be used in connection with numerical relays which operate with a constant sampling frequency but which adapt themselves to greater variations in the frequency of the fundamental tone by choosing, for calculation of amplitude and phase, an optimal number of sample points for an adaptive Fourier filter included in the relay. The parameters of the filter may be adapted for measurement of the amplitude and the phase of the fundamental tone/frequency of the alternating voltage, or of the harmonics of the alternating voltage.

BACKGROUND ART

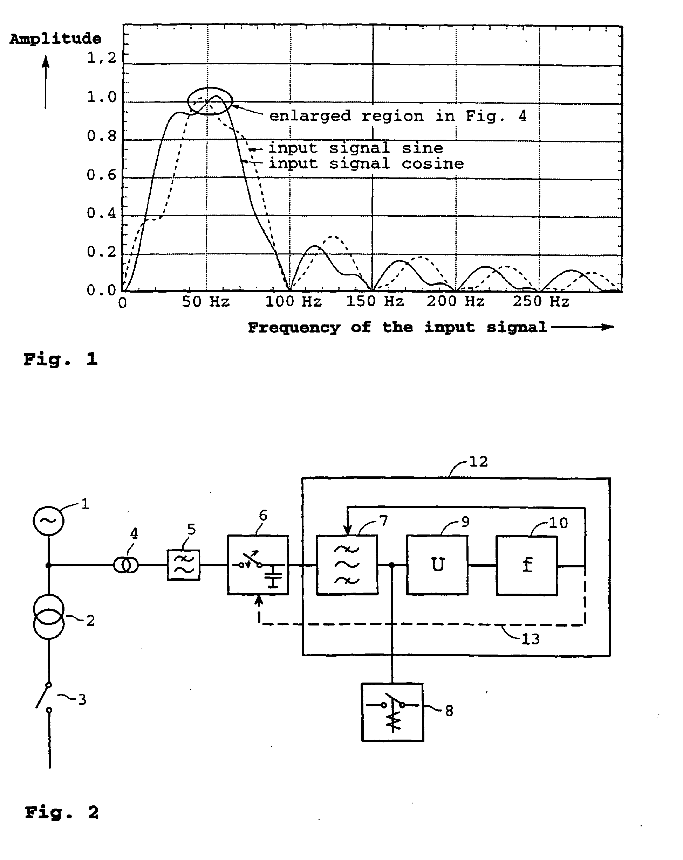

For relay and protective equipment for power generation and transmission installations as generators, transformers, high-voltage lines and switchgear, the amplitude and the phase angle of the fundamental tone of the mains voltage are fundamental measured values as input parameters for various monitoring and protective functions. For three-phase systems, the positive-sequence voltage is normally calculated from the three phase voltages towards ground. From the point of view of measurement technique, the positive-sequence voltage is more stable than each individual phase voltage. The positive-sequence voltage can be regarded as a vector starting from the origin of coordinates in the complex plane which rotates with the frequency of the mains voltage. In digital relay equipment, the fundamental tone is obtained from an input signal proportional to the mains voltage with the aid of a Fourier filter with the nominal frequency of the network in question, normally 50 or 60 Hz, as the fixed rated frequency of the filter. The rated frequency of the filter will hereinafter be referred to as the filter frequency. The filter is based on a fixed number of samples and on the sampling frequency being constant. The amplitude of the output signal of such a filter as a function of the frequency of the input signal for a sine- or cosine-wave input signal with an amplitude 1 is shown in Figure 1 when working with 20 samples per cycle of the filter frequency. The amplitude of the output signal of the filter with such an input signal will be referred to below as the amplitude response of the filter. Three important properties of such a filter are clear from the figure, namely:

1) The filter for calculating the amplitude of the fundamental tone completely suppresses all harmonics to the filter frequency.

2) The amplitude response is phase-dependent for all frequencies other than the filter frequency and its harmonics. This is shown in Figure 1 where the amplitude response of the filter to a sine-wave or cosine-wave alternating voltage is shown. The amplitude response for a sinusoidal voltage is shown in unbroken line, the amplitude response to a cosine-wave voltage by a broken line. For greater frequency variations of the alternating voltage, the amplitude response is smaller than 1 and will, in addition, oscillate in time between the unbroken and broken limits in Figure 1.

3) The amplitude response of the filter deviates from 1 even for small deviations $\Delta f$ from the filter frequency $f$ of the input signal of the filter. The deviation is in the first order $\Delta f/2f$ or 1%/Hz for a filter frequency of 50 Hz.

The combination of 2) and 3) creates large instability zones. Within these zones the amplitude of the output signal oscillates between the amplitude of the output signal of a sine-wave and cosine-wave input signal. Related to the property 1) the relation is that a pure sine-wave or cosine-wave input signal with a frequency which deviates somewhat from the filter frequency results in an output signal which contains harmonics. This can be used for measuring the frequency of the fundamental tone, where the amplitude which "leaks in" at the harmonics is taken as a measure of the frequency deviation. This is shown, inter alia, in US 4,319,329.
Within many fields of use, only very small frequency variations occur, for example in large power networks. The deviations because of the properties 2) and 3) of the filter are then negligible. The small frequency deviations $\Delta f$ which occur can then be measured, for example with the aid of the above-mentioned "leakage effect".
By measuring the angular velocity difference $\Delta\omega = 2\pi\Delta f$ between the positive-sequence voltage and a reference vector for the filter frequency in the complex plane, the mains frequency can be measured with better accuracy. This method is described in detail in the article "A New Measurement Technique for Tracking Voltage Phasors, Local System Frequency and Rate of Change of Frequency" by A.G. Phadke, J.S. Thorp and M.G. Adamiak, IEEE Trans. on PAS., Vol. 102, No. 5, May 1983, pp. 1025-1038.
However, there are situations where power plants can be subjected to great frequency variations. One example is when starting generators and transformers connected thereto. Another example is in systems for ac generation which are connected to power transmission by means of high-voltage direct current. Here, suddenly, the connection and disconnection of a direct-voltage line may lead to considerable frequency variations. In such situations, it may be difficult to determine the amplitude, phase and frequency of the mains voltage with an acceptable accuracy.

One solution to the above problem is described, inter alia, in the article "open System Relaying" by P.G. McLaren et al, IEEE Trans. on Power Delivery, Vol. 9, No. 3, July 1994, pp. 1316-1324. According to this article, the frequency is measured with a method based on the rotation of the positive-sequence voltage compared with the reference vector of the filter frequency. The frequency value is returned to a sampling unit where the sampling frequency is adjusted by adaptation of the time between each sample in such a way that one cycle of the fundamental tone always corresponds to that number of sample points of which the filter is composed. The sampling frequency is updated continuously such that a dynamic adaptation to the fundamental frequency is obtained.

The described method provides correct measurement of the frequency, amplitude and phase of the fundamental tone and may be caused to follow rapid changes in frequency. One disadvantage with the method, however, is that the fixed sampling frequency must be abandoned. This requires more complicated equipment for data acquisition and results in the availability of synchronously acquired data needed for other protective and relay functions being lost. Synchronously acquired data are important, inter alia, for digital oscillography of the course of the interference for later evaluation. If it is desired to maintain a synchronous data acquisition and hence a constant sampling frequency, it is thus required that parts of the equipment are doubled.

SUMMARY OF THE INVENTION

The problem is solved with a measuring method according claim 1.

The idea behind the invention is to combine a sampling unit with a constant sampling frequency with an adaptive Fourier filter which is adapted with respect to the number of sample points in such a way that the deviation between the filter frequency and the measured mains frequency is minimized. If, for example, the mains frequency is 50 Hz and if the sampling frequency is 1000 Hz, the filter is based on 20 samples for as long as the frequency does not deviate more than a few per cent from 50 Hz. If the frequency has dropped to, for example, 48 Hz, the optimal number of samples is 21 which corresponds to an exact filter for 47.62 Hz. If the frequency has risen to 52 Hz, the optimal number of samples is 19 corresponding to an exact filter for 52.63 Hz. The sampling frequency, 1000 Hz, remains unchanged while at the same time synchronously acquired signals and the time reference for other protective and relay functions are maintained.

Adapting the number of samples of the adaptive filter, in accordance with the invention, entails the following steps:

- determining the amplitude of the relevant phase voltages with the aid of adaptive Fourier filters, according to the method described below under the "Description of the preferred embodiments", and wherein the Fourier coefficients of the filter are adapted to the nominal fundamental tone/frequency of the network as a starting value;
- determining, in conventional manner, the relevant positive-sequence voltage based on the measured phase voltages;
- determining the fundamental tone/frequency of the relevant phase voltages by determining the difference between the rotational frequency of the reference vector of the adaptive filter, initially adapted to the nominal fundamental tone/frequency of the network, and the rotational frequency of the relevant positive-sequence voltage;
- restoring the relevant fundamental tone/frequency, determined in this way, to the adaptive filter;
- that the adaptive filter selects that number of samples which corresponds to a filter frequency as close to the relevant determined fundamental tone/frequency as possible;
- if the selected number of samples has been changed, the Fourier coefficients of the adaptive filter are adapted to the new number of samples with Fourier coefficients set up for each selected number of samples;
- determining the amplitude and the phase of the relevant phase voltages based on the relevant fundamental tone/ frequency and Fourier coefficients.

The method described can also be applied to various harmonics of the alternating voltage.

All of the above functions are programmed into the software of the adaptive filter. Thus, the hardware of the relay in other respects need not be changed compared with equipment intended for applications in which only small frequency variations may arise and which operates with both a constant sampling frequency and a constant number of samples for the filter.

BRIEF DESCRIPTION OF THE DRAWINGS

Figure 1 shows the amplitude of the output signal of a Fourier filter with a fixed filter/sampling frequency as a function of the frequency and phase of the input signal.

Figure 2 is a diagram showing the principle of one embodiment of the invention.

Figure 3 shows the positive-sequence voltage for 45 Hz after the filtering with a filter for 50 Hz in a coordinate system which follows the reference vector of the filter.

Figure 4 is an enlargement of Figure 1 for a frequency range around the nominal mains frequency 50 Hz and which also shows the amplitude of the output signal of an adaptive Fourier filter according to the invention.

Figures 5 - 7 show the results from an adaptive Fourier filter according to the invention for frequency reduction and frequency restoration from 50 Hz to 42 Hz and back to 50 Hz.

DESCRIPTION OF THE PREFERRED EMBODIMENTS

An elementary diagram of one embodiment of the invention is shown in Figure 2. An installation which may exhibit great frequency variations may comprise a generator 1 directly connected to a transformer 2, where the connection to the network during start-up of the generator is disconnected via a circuit breaker 3. Via an instrument transformer 4 and an analog or discrete prefilter 5, which filters away highfrequency components, the voltage signal is passed to a sampling device 6 with a constant sampling frequency. The sampled signal values are fed into an adaptive Fourier filter 7. This is done for all three phases. After the filtering, the thus obtained fundamental-tone amplitudes for the three phases are used, on the one hand, for different monitoring, protective and relay functions 8, and on the other hand, there is calculated in a first calculating unit 9 the positive-sequence voltage which is used for calculation in a second calculating unit 10 of the frequency of the fundamental tone. The value of the frequency thus obtained is fed back via the unbroken line to the adaptive Fourier filter 7, where the optimal number of sample points for the filter, for the measured frequency, is selected. The Fourier filter, the calculation of the positive-sequence voltage and the frequency determination are all parts of the same software 12. The feedback thus takes place within the scope of the software.
By way of comparison, the feedback of the frequency to the sampling device 6, according to the frequency adaptation method described under the background art, is shown as a broken line 13. As will clear from the above, this method requires a sampling device with a variable sampling frequency since the frequency adaptation cannot be made, in all respects, within the software.
The three phase voltages are calculated with the aid of a Fourier filter algorithm as follows:

$$Y_{c1}(i) = \frac{2}{N_s} \cdot \sum_{j=i-N_s+1}^{i} y(j) \cdot \cos(j \cdot \Theta) \qquad Y_{s1}(i) = -\frac{2}{N_s} \cdot \sum_{j=i-N_s+1}^{i} y(j) \cdot \sin(j \cdot \Theta)$$

$$Y_1(i) = \sqrt{(Y_{c1}(i))^2 + (Y_{s1}(i))^2}$$

$Y_{c1}$      the real part of the fundamental tone of the phase voltage
$Y_{s1}$,     the imaginary part of the fundamental tone of the phase voltage
$Y_1$       the amplitude of the fundamental tone of the phase voltage
$y$        the instantaneous value of the input signal
$(i)$       index for the last calculated value
$(j)$       index for the j'th of the last $N$, input signals
$N_s$       the number of samples per cycle
$\Theta$        the angle between consecutive samples: $\Theta = 2\pi/N_s$.

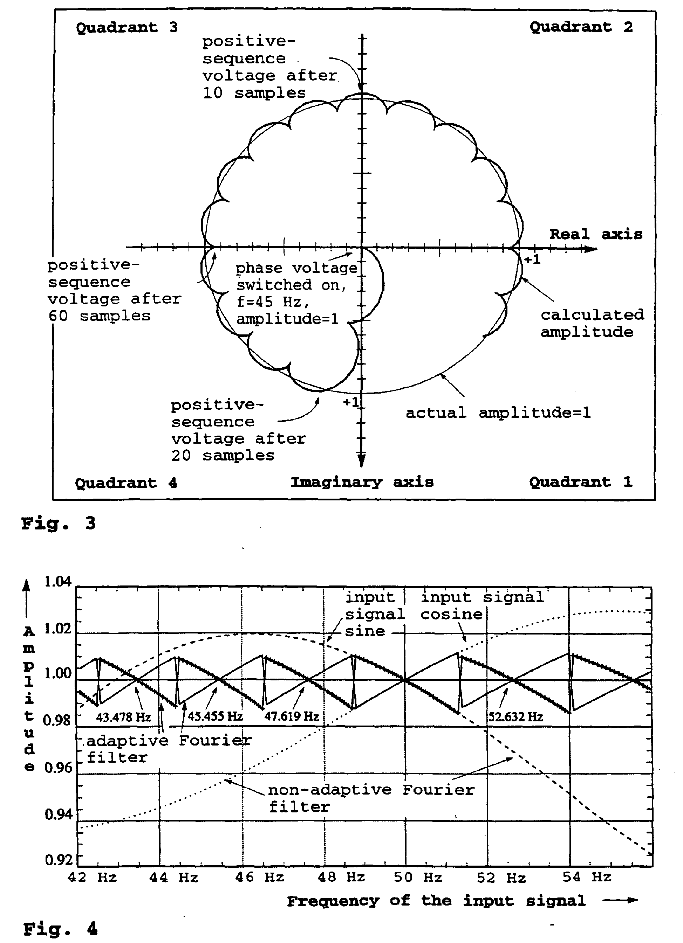

From the three phase voltages, the positive-sequence voltage is calculated in the normal way. The formation of the average value and the reduction of "aliasing effects" result in the positive-sequence voltage representing a more relevant value than each phase voltage separately.
The reference vector of the filter frequency $f_0$ is selected to be at rest in the complex plane. If the frequency $f$ of the measured positive-sequence voltage coincides with the filter frequency, both the reference vector and the positive-sequence voltage are at rest. As soon as the filter frequency and the frequency of the positive-sequence voltage deviate from each other, the positive-sequence voltage rotates in relation to the reference vector by, on average, the difference frequency $\Delta f = f - f_0$. The rotation is clockwise if the signal frequency is smaller than the fundamental frequency of the filter and counterclockwise if the signal frequency is higher than the fundamental frequency of the filter. The fact that this only applies as an average value is clear from Figure 3 which shows in a coordinate system how the positive-sequence voltage follows the reference vector for the frequency $f = 45Hz$ of the positive-sequence voltage after filtering with a fixed Fourier filter with $f_0$=50$Hz$ as filter frequency and 20 samples per cycle. After the starting transient, the positive-sequence voltage varies cyclically in magnitude and angular velocity. On average, the positive-sequence voltage rotates in the clockwise direction with $\Delta f = 5Hz$. By calculating the difference frequency over an interval of some, for example four, of the cycles of the filter, however, a very accurate value of $\Delta f$ and hence also the mains frequency $f$ may be obtained.

After the calculation of the relevant mains frequency, it is checked whether the number of samples for the modified Fourier filter is still optimal or whether it needs to be adjusted, such that the new corresponding fundamental frequency of the filter deviates to a lesser degree from the signal frequency. With the nominal filter frequency $f_0$ corresponding to the nominal mains frequency (e.g. 50 Hz) and the associated nominal number of samples $N_0$ the filter frequencies become $\tilde{f}_0$ which is used for major frequency deviations $\tilde{f}_0 = f_0 \cdot (N_s/N_0)$ where $N_s$ is the relevant number of samples. As an example, a mains frequency $f = 48Hz$ is measured. The optimum number of samples for the filter then becomes $N_s$=19 with the fundamental frequency of the filter being $\tilde{f}_0 = 47.62Hz$.

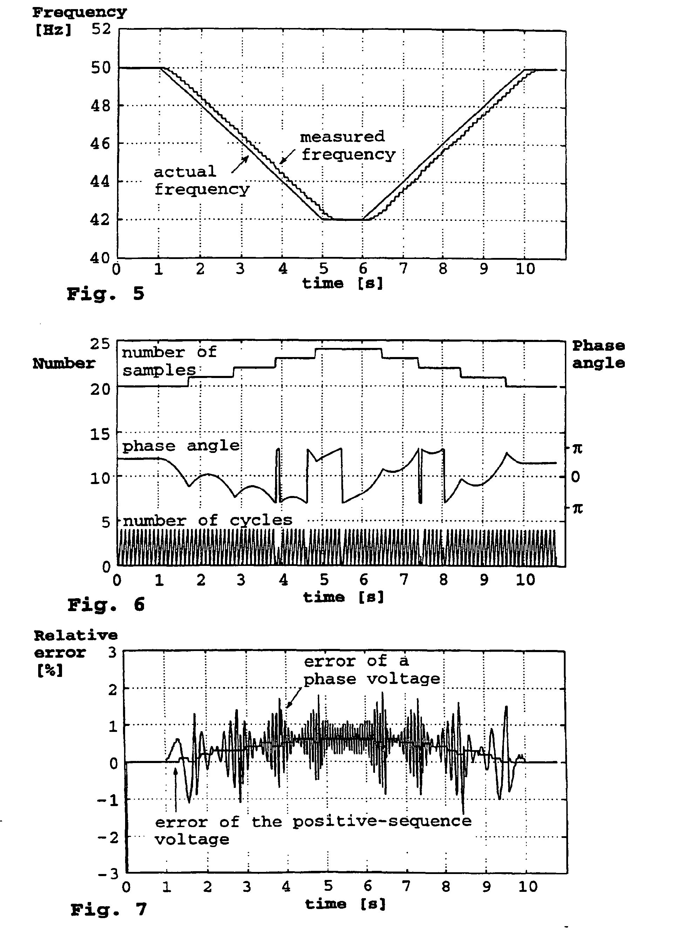

As is clear from Figure 4, the error in the measured amplitude can be maintained within +/- 1.5% with this method. To function in practice, the frequency calculation and the adjustment of the filter must be supplemented with safety routines for very fast frequency changes, interruptions and the like. The number of cycles for the frequency calculation, usually four, can be adjusted downwards. As examples, Figures 5-7 show the results from a modified Fourier filter according to the invention for a frequency reduction and restoration from 50 Hz to 42 Hz and back to 50 Hz at a rate of change of the frequency of 2 Hz/s. Figure 5 shows how the calculated mains frequency follows the actual mains frequency. Figure 6 shows the number of samples of the filter, the phase of the positive-sequence voltage, and the number of cycles for the frequency calculation as a function of the time. Figure 7 shows the error of the amplitude for one of the phase voltages towards ground and for the positive-sequence voltage as a function of the time. It can be read that the error of the amplitude of the positive-sequence voltage remains well below 1%.

## Claims

1. A measuring method for determining the amplitude and the phase of the fundamental tone of an alternating voltage in an ac network having a nominal fundamental frequency, wherein the determination is performed in a numerical relay (12) which is based on a constant sampling frequency and which comprises a Fourier filter (7) having a filter frequency and a number of sample points, for determining the amplitude and the phase of the alternating voltage, which measuring method is **characterized in that** the Fourier filter is an adaptive Fourier filter in which the number of sample points is adaptable and **in that** the method is comprising a step of adapting the number of sample points in such a way that the deviation between the filter frequency of the adaptive filter, adapted to the nominal fundamental frequency of the ac network, and a fundamental tone frequency determined with a calculating unit (10) is minimized.

2. A measuring method for determining the amplitude and the phase of the fundamental tone of an alternating voltage in an ac network having a nominal fundamental frequency, according to claim 1,
   **characterized in that** the step of adapting the number of H sample points includes that the amplitude of the phase voltages of the ac network is determined with the adaptive filter (7) with Fourier coefficients adapted to the nominal fundamental frequency of the ac network as a starting value, and that
   the relevant positive-sequence voltage based on the phase voltages is determined with a first calculating unit (9), and that
   the relevant fundamental tone frequency of the phase voltages is determined with a second calculating unit (10) by determining the difference between the rotational frequency of the reference vector of the adaptive filter, initially adapted to the nominal fundamental frequency of the network and the rotational frequency of the positive-sequence voltage, and that
   the relevant fundamental tone frequency thus determined is restored to the adaptive Fourier filter, and that the number of samples is chosen which corresponds to a filter frequency of the adaptive filter as close to the relevant determined fundamental tone frequency as possible, and that the Fourier coefficients of the adaptive filter are adapted to the chosen number of samples, and that
   the amplitude and the phase of the relevant phase voltages are determined based on the relevant fundamental tone frequency of the ac network.

**Patentansprüche**

1. Messverfahren zum Bestimmen der Amplitude und der Phase des Grundtons einer Wechselspannung in einem Wechselstromnetz mit einer nominalen Grundfrequenz, wobei die Bestimmung in einem numerischen Relais (12) durchgeführt wird, basierend auf einer konstanten Abtastfrequenz, und umfassend einen Fourierfilter (7) mit einer Filterfrequenz und einer Anzahl von Abtastpunkten zum Bestimmen der Amplitude und der Phase der Wechselspannung, wobei das Messverfahren **dadurch gekennzeichnet ist, dass** der Fourierfilter ein adaptiver Fourierfilter ist, bei dem die Anzahl der Abtastpunkte anpassbar ist, und dadurch, dass das Verfahren einen Schritt des Anpassens der Anzahl von Abtastpunkten auf eine solche Weise umfasst, dass die Abweichung zwischen der Filterfrequenz des adaptiven Filters, angepasst an die nominale Grundfrequenz des Wechselstromnetzes, und einer Grundtonfrequenz, die mit einer Berechnungseinheit (10) bestimmt wird, minimiert wird.

2. Messverfahren zum Bestimmen der Amplitude und der Phase des Grundtons einer Wechselspannung in einem Wechselstromnetz mit einer nominalen Grundfrequenz nach Anspruch 1,
   **dadurch gekennzeichnet, dass** der Schritt des Anpassens der Anzahl von Abtastpunkten einschließt, dass die Amplitude der Phasenspannungen des Wechselstromnetzes mit dem adaptiven Filter (7) mit Fourierkoeffizienten bestimmt wird, die an die nominale Grundfrequenz des Wechselstromnetzes als Anfangswert angepasst sind, und dass
   die relevante Mitsystem-Spannung basierend auf den Phasenspannungen mit einer ersten Berechnungseinheit (9) bestimmt wird, und dass
   die relevante Grundtonfrequenz der Phasenspannungen mit einer zweiten Berechnungseinheit (10) durch Bestimmen der Differenz zwischen der Drehfrequenz des Referenzvektors des adaptiven Filters, anfangs angepasst an die nominale Grundfrequenz des Netzes, und der Drehfrequenz der Mitsystem-Spannung bestimmt wird, und dass die relevante Grundtonfrequenz, die so bestimmt wurde, an den adaptiven Fourierfilter zurückgegeben wird, und dass die Anzahl von Abtastwerten gewählt wird, die einer Filterfrequenz des adaptiven Filters entspricht, welche so nah wie möglich an der relevanten bestimmten Grundtonfrequenz liegt, und dass die Fourierkoeffizienten des adaptiven Filters an die gewählte Anzahl von Abtastwerten angepasst werden, und dass
   die Amplitude und die Phase der relevanten Phasenspannungen auf Grundlage der relevanten Grundtonfrequenz des Wechselspannungsnetzes bestimmt werden.

**Revendications**

1. Procédé de mesure permettant de déterminer l'amplitude et la phase du son fondamental d'une tension alternative dans un réseau à courant alternatif ayant une fréquence fondamentale nominale, dans lequel la détermination est effectuée dans un relais numérique (12) qui repose sur une fréquence d'échantillonnage constante et qui comprend un filtre de Fourier (7) ayant une fréquence de filtrage et un nombre de points échantillons, permettant de déterminer l'amplitude et la phase de la tension alternative, lequel procédé de mesure est **caractérisé en ce que** le filtre de Fourier est un filtre de Fourier adaptatif, dans lequel le nombre de points échantillons est adaptable et **en ce que** le procédé comprend une étape, consistant à adapter le nombre de points échantillons d'une manière telle que l'écart entre la fréquence de filtrage du filtre adaptatif, adapté à la fréquence fondamentale nominale du réseau à courant alternatif et une fréquence du son fondamental, déterminé avec une unité (10) de calcul, est minimisé.

2. Procédé de mesure, permettant de déterminer l'amplitude et la phase du son fondamental d'une tension alternative dans un réseau à courant alternatif ayant une fréquence fondamentale nominale selon la revendication 1, **caractérisé**
   **en ce que** l'étape d'adaptation du nombre de points échantillons comporte le fait qui veut que l'amplitude des tensions entre phases du réseau à courant alternatif soit déterminée avec le filtre adaptatif (7) avec des coefficients de Fourier adaptés à la fréquence fondamentale nominale du réseau à courant alternatif en tant que valeur de départ et
   **en ce que** la tension directe pertinente, reposant sur les tensions entre phases, est déterminée avec une première unité de calcul (9) et
   **en ce que** la fréquence pertinente du son fondamental des tensions entre phases est déterminée avec une seconde unité de calcul (10), en déterminant la différence entre la fréquence de rotation du vecteur de référence du filtre adaptatif, initialement adaptée à la fréquence fondamentale nominale du réseau et la fréquence de rotation de la tension directe et
   **en ce que** la fréquence pertinente du son fondamental ainsi déterminée est rétablie au filtre adaptatif de Fourier et
   **en ce que** le nombre d'échantillons est choisi, qui correspond à une fréquence de filtrage du filtre adaptatif la plus proche possible de la fréquence pertinente déterminée du son fondamental et

**en ce que** les coefficients de Fourier du filtre adaptatif sont adaptés au nombre choisi d'échantillons et

**en ce que** l'amplitude et la phase des tensions de phase pertinentes sont déterminées en fonction de la fréquence pertinente du son fondamental du réseau à courant alternatif.

Fig. 1

Fig. 2

Fig. 3

Fig. 4

**Fig. 5**

**Fig. 6**

**Fig. 7**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4319329 A

**Non-patent literature cited in the description**

- **A.G. PHADKE ; J.S. THORP ; M.G. ADAMIAK.** A New Measurement Technique for Tracking Voltage Phasors, Local System Frequency and Rate of Change of Frequency. *IEEE Trans. on PAS.,* May 1983, vol. 102 (5), 1025-1038

- **P.G. MCLAREN et al.** open System Relaying. *IEEE Trans. on Power Delivery,* July 1994, vol. 9 (3), 1316-1324